# FASCICULE DE BREVET EUROPEEN

(11) **EP 3 903 354 B1**
(45) Date de publication et mention de la délivrance du brevet: **12.06.2024**
(21) Numéro de dépôt: 19848989.0
(22) Date de dépôt: 23.12.2019
(51) Int. Cl.: H01L 33/18, H01L 33/58, H01L 33/24

(54) **DISPOSITIF OPTOÉLECTRONIQUE À DIODE ÉLECTROLUMINESCENTE MICROMÉTRIQUE OU NANOMÉTRIQUE SURMONTÉE D'UNE LENTILLE OPTIQUE**
OPTOELEKTRONISCHE VORRICHTUNG MIT EINER MIKROMETRISCHEN ODER NANOMETRISCHEN LICHTEMITTIERENDEN DIODE, DIE MIT EINER OPTISCHEN LINSE ÜBERZOGEN IST
OPTOELECTRONIC DEVICE WITH A MICROMETRICAL OR NANOMETRICAL LIGHT-EMITTING DIODE SURMOUNTED BY AN OPTICAL LENS

(30) Priorité: 28.12.2018 FR 1874318
(43) Date de publication de la demande: 03.11.2021
(73) Titulaire: Aledia, 38130 Echirolles (FR)
(72) Inventeur: JEANNIN, Olivier, 38000 Grenoble (FR); MAYER, Frédéric, 38500 VOIRON (FR)
(74) Mandataire: Germain Maureau
(86) Numéro de dépôt international: PCT/FR2019/053290
(87) Numéro de publication internationale: WO 2020/136349

(56) Documents cités:
- EP-A1- 2 806 470
- EP-B1- 3 811 412
- WO-A1-2008/079078
- WO-A1-2017/025445
- WO-A1-2019/243743
- FR-A1- 3 058 572
- US-A1- 2010 065 863
- US-A1- 2011 133 060
- US-A1- 2015 129 834
- US-A1- 2015 144 873
- US-A1- 2018 301 594

## Description

### DOMAINE TECHNIQUE

La présente invention concerne un dispositif optoélectronique comportant un substrat délimitant une face support et au moins une diode électroluminescente formée sur la face support, la diode électroluminescente ayant une forme tridimensionnelle comportant une hauteur suivant un axe longitudinal s'étendant selon une première direction orientée transversalement à la face support.

L'invention concerne également un procédé de fabrication d'un dispositif optoélectronique.

L'invention trouve une application notamment dans les écrans d'affichage ou les systèmes de projection d'images.

### ETAT DE LA TECHNIQUE ANTERIEURE

Par « dispositif optoélectronique », il est ici entendu un dispositif adapté pour effectuer la conversion d'un signal électrique en un rayonnement électromagnétique à émettre, notamment de la lumière.

Il existe des dispositifs optoélectroniques comportant des diodes électroluminescentes, également connues sous l'acronyme LED pour « light-emitting diode » selon la terminologie anglo-saxonne consacrée, formées sur un substrat.

Il est connu que chaque diode électroluminescente comprenne un matériau actif exploitant ou non des puits quantiques, une portion semiconductrice dopée selon un premier type de dopage pour jouer le rôle de jonction dopée P et une portion semiconductrice dopée selon un deuxième type de dopage pour jouer le rôle de jonction dopée N.

Chaque diode électroluminescente peut être formée sur la base d'éléments tridimensionnels semiconducteurs micrométriques voire nanométriques, eux-mêmes au moins partiellement obtenus par croissance par épitaxie de type dépôt en phase vapeur d'organométalliques (MOCVD) ou de type épitaxie par jets moléculaires (MBE) ou de type épitaxie en Phase vapeur aux Hydrures (HVPE). Les diodes électroluminescentes sont typiquement formées à base d'un matériau semiconducteur comprenant par exemple des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AIGaN).

Il existe des dispositifs optoélectroniques comportant une matrice de diodes électroluminescentes présentant une certaine surface d'émission au travers de laquelle est transmis le rayonnement lumineux émis par les diodes électroluminescentes. De tels dispositifs optoélectroniques peuvent notamment être utilisés dans la constitution d'écrans d'affichage ou de systèmes de projection d'images, où la matrice de diodes électroluminescentes définit en fait une matrice de pixels lumineux où chaque pixel comporte traditionnellement au moins un sous-pixel pour générer chaque couleur, chaque sous-pixel contenant lui-même au moins une diode électroluminescente. Un sous-pixel peut par exemple contenir jusqu'à 100000 diodes électrolu m inescentes.

L'une des difficultés est qu'à mesure où la définition des écrans augmente, les dimensions entre les diodes électroluminescentes et les dimensions de chaque sous-pixel deviennent micrométriques, voire nanométriques, et l'emploi de diodes électroluminescentes tridimensionnelles devient inéluctable avec des dimensions de diodes électroluminescentes tridimensionnelles toujours plus petites. Or, l'intensité lumineuse émise par les diodes électroluminescentes tridimensionnelles nanométriques décroît drastiquement à mesure que la taille des diodes électroluminescentes tridimensionnelles se réduit.

Une autre difficulté est de parvenir à ce que le rayonnement lumineux émis par les diodes électroluminescentes tridimensionnelles d'un sous-pixel ne se mélange pas avec le rayonnement lumineux émis par les diodes électroluminescentes d'un sous-pixel adjacent afin d'améliorer les contrastes. Or, cette problématique s'avère de plus en plus difficile à résoudre compte tenu de la miniaturisation croissante des diodes électroluminescentes.

Une autre difficulté provient du fait que la lumière émise par une diode tridimensionnelle n'est pas directionnelle. Il en ressort une perte importante de rayonnement par émission dans des directions non désirées, entraînant ainsi une chute de l'efficacité lumineuse et du rendement global.

Une solution connue consiste à former des parois de confinement lumineux aptes à bloquer la transmission du rayonnement lumineux émis par au moins une diode électroluminescente donnée vers au moins une diode électroluminescente adjacente.

Mais cette technique connue ne répond pas au besoin de rendre les rayons lumineux directionnels ou focalisés et il en résulte en outre une perte partielle du rayonnement lumineux par absorption à travers les parois de confinement lumineux, faisant chuter l'efficacité lumineuse et le rendement global.

Le document US2015/144873A1 décrit un dispositif optoélectronique comportant une diode électroluminescente ayant une forme tridimensionnelle, ainsi qu'une lentille formée au-dessus de la diode électroluminescente.

### EXPOSE DE L'INVENTION

La présente invention a pour but de répondre à tout ou partie des problèmes présentés ci-avant.

Notamment, un but est de fournir une solution répondant à au moins l'un des objectifs suivants :
- focaliser ou rendre les rayons lumineux émis par une diode électroluminescente tridimensionnelle les plus directionnels possibles ;
- augmenter l'efficacité lumineuse du dispositif optoélectronique ;
- permettre d'obtenir une intensité lumineuse émise par une diode électroluminescente tridimensionnelle aussi élevée que possible.

Ce but peut être atteint grâce à la fourniture d'un dispositif optoélectronique tel que revendiqué à la revendication 1..

Certains aspects préférés mais non limitatifs du dispositif sont les suivants.

Le diamètre maximal est compris entre 0,1 µm et 20 µm.

La lentille optique est formée dans un matériau ayant un indice optique compris entre 1,4 et 2,2.

Au moins une partie de la diode électroluminescente comprend une couche de passivation.

La lentille optique et la partie distale de la diode électroluminescente sont en contact mécanique.

Au moins une partie de la lentille optique et la partie distale de la diode électroluminescente sont séparées l'une de l'autre avec interposition d'une distance comprise entre 5 nm et 20 µm.

Un matériau optique, d'indice optique compris entre 1,4 et 2,2 et inférieur ou égal à un indice optique de la lentille optique, remplit tout ou partie de l'espace compris entre la partie distale de la diode électroluminescente et la partie de la lentille optique tournée vers la partie distale de la diode électroluminescente.

Tout ou partie de la diode électroluminescente est entourée par un matériau d'encapsulation.

Vu perpendiculairement à l'axe longitudinal, le matériau d'encapsulation est entouré par au moins une paroi apte à réfléchir les rayons lumineux émis par la diode électroluminescente.

L'invention porte également sur la mise en oeuvre d'un procédé de fabrication d'un dispositif optoélectronique tel que revendiqué à la revendication 8.

Certains aspects préférés mais non limitatifs du procédé sont les suivants.

Le procédé de fabrication comprend les étapes suivantes, mises en oeuvre entre l'étape b) et l'étape i) :
c) formation d'un matériau d'encapsulation entourant tout ou partie de la diode électroluminescente ;
d) formation, sur la face exposée de la structure intermédiaire obtenue à l'étape c), d'une première couche de matériau optique, d'indice optique compris entre 1,4 et 2,2 et inférieur ou égal à un indice optique de la lentille optique, ladite première couche de matériau optique ayant une aptitude à être gravée de façon isotrope par la mise oeuvre d'une première méthode de gravure ;
e) formation, sur la surface libre de la structure intermédiaire obtenue après l'étape d), d'une couche de masque dur ayant une aptitude à ne pas être gravée lors de l'utilisation de la première méthode de gravure ;
f) gravure d'une première ouverture, par la mise en oeuvre d'une deuxième méthode de gravure, à travers la couche de masque dur obtenue à l'étape e), la première ouverture correspondant à une section de coupe de la diode électroluminescente suivant un plan parallèle à la face support, ladite première ouverture de la couche de masque dur étant située au-dessus de la diode électroluminescente dans le prolongement de l'axe longitudinal ;
g) gravure d'au moins une cavité, par la mise en oeuvre de la première méthode de gravure au niveau de la première ouverture obtenue à l'étape f), dans tout ou partie de l'épaisseur de la première couche de matériau optique , la cavité ainsi obtenue ayant une forme concave complémentaire de la surface convexe de la lentille optique et étant adaptée à la formation ultérieure de la lentille optique à l'étape i) directement dans la cavité ;
h) retrait de la couche de masque dur.

L'étape i) peut comprendre les étapes suivantes :
i1) formation d'une couche de polymère sur la surface exposée de la structure intermédiaire obtenue après l'étape h), la couche de polymère remplissant tout ou partie de la cavité ;
i2) gravure de la couche de polymère localisée au niveau d'au moins une portion à retirer, permettant de conserver au moins une portion résiduelle de la couche de polymère située à l'aplomb de la diode électroluminescente dans le prolongement de l'axe longitudinal ;
i3) recuit de ladite au moins une portion résiduelle, le recuit étant réalisé dans des conditions permettant de faire passer le polymère constitutif de ladite au moins une portion résiduelle par un état visqueux.

Le procédé de fabrication peut comporter une étape j) de formation d'au moins une paroi apte à réfléchir les rayonnements lumineux émis par la diode électroluminescente, la paroi s'étendant depuis la face support sensiblement parallèlement à l'axe longitudinal.

### BREVE DESCRIPTION DES DESSINS

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
[Fig. 1] représente une coupe transversale schématique d'une diode électroluminescente pouvant être utilisée dans l'invention ;
[Fig. 2] représente une coupe transversale schématique d'un premier mode de réalisation d'un dispositif optoélectronique selon l'invention contenant une diode électroluminescente ;
[Fig. 3] illustre une coupe transversale schématique d'un deuxième mode de réalisation d'un dispositif optoélectronique selon l'invention contenant une diode électroluminescente ;
[Fig. 4] représente une coupe transversale schématique d'un troisième mode de réalisation d'un dispositif optoélectronique selon l'invention contenant une diode électroluminescente ;
[Fig. 5] illustre une coupe transversale schématique d'un quatrième mode de réalisation d'un dispositif optoélectronique selon l'invention contenant une diode électroluminescente ;
[Fig. 6] représente en coupe transversale schématique une première étape d'un premier exemple de procédé de fabrication d'un dispositif optoélectronique selon l'invention ;
[Fig. 7] représente en coupe transversale schématique une deuxième étape du premier exemple de procédé de fabrication ;
[Fig. 8] représente en coupe transversale schématique une troisième étape du premier exemple de procédé de fabrication ;
[Fig. 9] représente en coupe transversale schématique une quatrième étape du premier exemple de procédé de fabrication ;
[Fig. 10] représente en coupe transversale schématique une cinquième étape du premier exemple de procédé de fabrication ;
[Fig. 11] représente en coupe transversale schématique une sixième étape du premier exemple de procédé de fabrication ;
[Fig. 12] représente en coupe transversale schématique une première étape d'un deuxième exemple de procédé de fabrication d'un dispositif optoélectronique selon l'invention ;
[Fig. 13] représente en coupe transversale schématique une deuxième étape du deuxième exemple de procédé de fabrication ;
[Fig. 14] représente en coupe transversale schématique une septième étape du premier exemple de procédé de fabrication ;
[Fig. 15] représente en coupe transversale schématique une étape d'un troisième exemple de procédé de fabrication d'un dispositif optoélectronique selon l'invention.

### EXPOSE DETAILLE DE MODES DE REALISATION PARTICULIERS

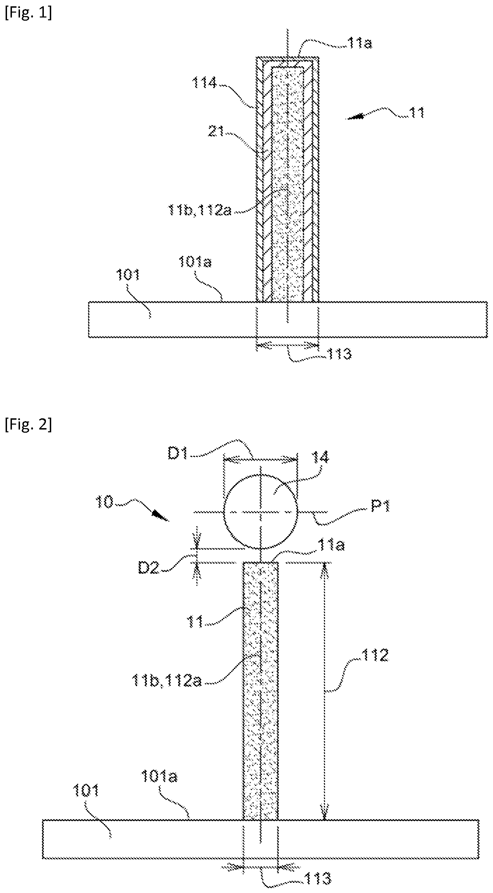

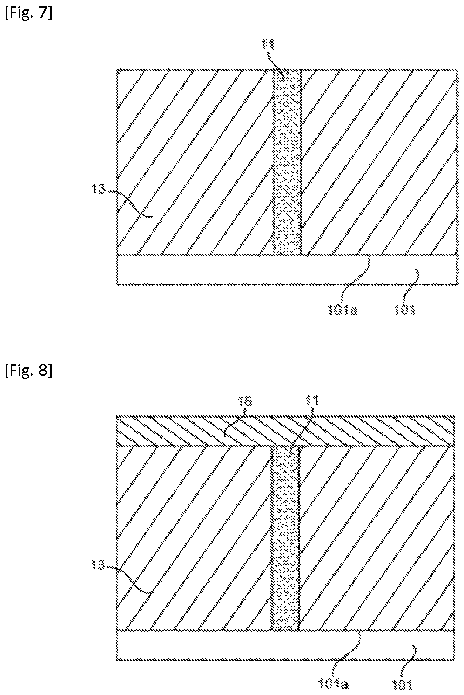

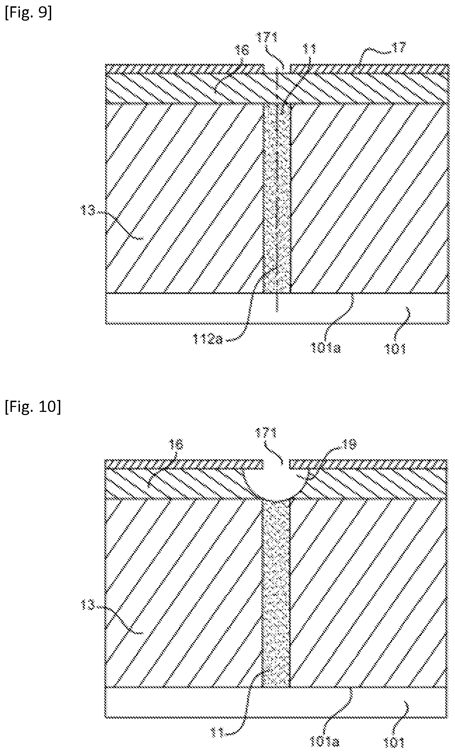

Sur les figures 1 à 15 annexées et dans la suite de la description, les mêmes références représentent des éléments identiques ou similaires. De plus, les différents éléments ne sont pas représentés à l'échelle de manière à privilégier la clarté des figures pour en favoriser la compréhension. Par ailleurs, les différents modes de réalisation et variantes ne sont pas exclusifs les uns des autres et peuvent au contraire être combinés entre eux.

Dans la suite de la description, sauf indication spécifique, les termes « sensiblement », « environ », « globalement » et « de l'ordre de » signifient « à 10 % près ».

A des fins d'illustration exclusivement, mais sans aucun caractère limitatif, chacune des figures 2 à 15 représente un dispositif optoélectronique 10 ne comprenant qu'une seule diode électroluminescente 11, ceci étant purement à titre illustratif. En effet, le nombre de diodes électroluminescentes 11 n'est pas limité en soi.

L'invention porte en premier lieu sur un dispositif optoélectronique 10, comportant au moins une diode électroluminescente 11 tridimensionnelle, ayant des dimensions micrométriques ou nanométriques, et dont les rayons lumineux émis sont focalisés ou rendus les plus directionnels possibles grâce à la présence d'au moins une lentille optique 14, décrite plus loin tant dans son agencement que dans sa méthode de formation.

L'invention porte également sur un procédé de fabrication d'un dispositif optoélectronique 10.

Grâce à l'arrangement de diodes électroluminescentes 11 tridimensionnelles associées à une lentille optique 14 micrométrique ou nanométrique, une application particulièrement visée est la fourniture d'un écran d'affichage d'images ou d'un dispositif de projection d'images.

Il est également clair que les modes de réalisation décrits dans ce document peuvent trouver des applications dans d'autres domaines, par exemple la détection ou la mesure de radiations électromagnétiques ou encore des applications photovoltaïques.

Le dispositif optoélectronique 10 comprend un substrat 101, ayant une face support 101a, qui est un élément commun aux différents modes de réalisation. La nature du substrat 101 peut être quelconque et n'apporte ici aucune limitation, tout substrat 101 connu et adapté à la mise en oeuvre de ce qui sera décrit plus loin pouvant être envisagé.

Le substrat 101 est constitué par exemple par un empilement d'une couche monolithique (non représentée), d'une couche d'électrode inférieure (non représentée) qui peut être une couche de germination conductrice et d'une première couche d'isolation électrique (non représentée). L'homme du métier peut se référer par exemple à la demande de brevet FR-A1-3053530 pour la formation et la fourniture d'un tel substrat.

La face support 101a du substrat 101 est constituée, par exemple, par la face exposée de la première couche d'isolation électrique évoquée ci-avant.

La couche monolithique peut être formée dans un matériau semiconducteur dopé ou non, par exemple du silicium ou encore du germanium, et plus particulièrement du silicium monocristallin. Il peut aussi être formé en saphir voire en un matériau semiconducteur III-V, par exemple en GaN. Il peut alternativement s'agir d'un substrat de type silicium sur isolant ou « SOI » pour « Silicon On Insulator » selon la terminologie anglo-saxonne consacrée. Alternativement, la couche monolithique peut être formée dans un matériau électriquement isolant.

La couche d'électrode inférieure sert à former une ou plusieurs premières électrodes inférieures et peut servir de couche de germination pour la croissance de portions de diodes électroluminescentes 11. La couche d'électrode inférieure peut être continue ou discontinue. Le matériau composant la couche d'électrode inférieure peut être un nitrure, un carbure ou un borure d'un métal de transition de la colonne IV, V ou VI du tableau périodique des éléments ou une combinaison de ces composés.

La première couche d'isolation électrique peut comprendre une première couche électriquement isolante intermédiaire qui recouvre la couche d'électrode inférieure. Outre ses propriétés d'isolation électrique, elle forme un masque de croissance autorisant la croissance, par exemple épitaxiale, de parties dopées des diodes électroluminescentes 11 à partir d'ouvertures traversantes délimitées par ce masque de croissance débouchant localement sur la couche d'électrode inférieure. La première couche d'isolation électrique participe également à assurer l'isolation électrique entre les premières électrodes inférieures (non représentées) et les secondes électrodes 21 (visibles sur la figure 1). La première couche isolante intermédiaire est réalisée dans au moins un matériau diélectrique tel que, par exemple, un oxyde de silicium (par exemple SiO₂ ou SiON) ou un nitrure de silicium (par exemple Si₃N₄ ou SiN), voire un oxynitrure de silicium, un oxyde d'aluminium (par exemple Al₂O₃) ou un oxyde de hafnium (par exemple HfO₂). L'épaisseur de la première couche isolante intermédiaire peut être comprise entre 5 nm et 1 µm, de préférence comprise entre 20 nm et 500 nm, par exemple égale à 100 nm environ.

La première couche d'isolation électrique peut comporter, en plus de la première couche isolante intermédiaire, une deuxième couche isolante intermédiaire (non représentée) qui recouvre les premières électrodes inférieures et participe à assurer l'isolation électrique entre les premières électrodes inférieures et les secondes électrodes supérieures 21. La deuxième couche électriquement isolante intermédiaire peut recouvrir également le masque de croissance formé par la première couche isolante intermédiaire. La deuxième couche isolante intermédiaire peut être réalisée en un matériau diélectrique identique ou différent de celui du masque de croissance, tel que, par exemple, un oxyde de silicium (par exemple SiO₂) ou un nitrure de silicium (par exemple Si₃N₄ ou SiN), voire un oxynitrure de silicium, un oxyde d'aluminium (par exemple Al₂O₃) ou un oxyde de hafnium (par exemple HfO₂). L'épaisseur de la deuxième couche isolante intermédiaire peut être comprise entre 5 nm et 1 µm, de préférence comprise entre 20 nm et 500 nm, par exemple égale à 100 nm environ.

Au moins une diode électroluminescente 11 ayant une forme tridimensionnelle comprenant une hauteur suivant un axe longitudinal 11b est formée sur la face support 101a du substrat 101. Cet axe longitudinal 11b s'étend selon une première direction 112a orientée transversalement à la face support 101a du substrat 101. Notamment, la première direction 112a est sensiblement perpendiculaire au plan général dans lequel s'étend le substrat 101.

Chaque diode électroluminescente 11 comporte ainsi une partie proximale tournée vers la face support 101a du substrat 101 et, à l'opposé le long de la première direction 112a, une partie distale 11a opposée à la partie proximale. Notamment, la partie proximale de chaque diode électroluminescente 11 est formée sur la face support 101a du substrat, moyennant un contact électrique avec la couche d'électrode inférieure. Les diodes électroluminescentes 11 sont caractérisées par une première dimension dite longitudinale, notée 112, mesurée le long de l'axe longitudinal 11b entre la partie distale 11a et la partie proximale de la diode électroluminescente 11. Les diodes électroluminescentes 11 sont également caractérisées par une deuxième dimension dite transversale, notée 113, correspondant à une dimension comptée perpendiculairement à l'axe longitudinal 11b, notamment correspondant à la plus grande dimension de la section de coupe de la diode électroluminescente 11 considérée dans tout plan de coupe orienté perpendiculairement à l'axe longitudinal 11b. Dans le cas où les dimensions de la section de coupe évoluent le long de la hauteur de la diode électroluminescente 11, la deuxième dimension transversale considérée dans ce document correspond à la plus grande des valeurs prises par la plus grande dimension de toutes les sections de coupe sur toute la hauteur. La forme tridimensionnelle adoptée par chaque diode électroluminescente 11, aux dimensions nanométriques ou micrométriques, peut être une forme filaire globalement cylindrique, un cône ou un tronc de cône, ou encore une forme globalement pyramidale tandis que la section de coupe, régulière ou non le long de l'axe longitudinal 11b tant dans sa forme que dans ses dimensions, peut être circulaire ou non, par exemple ovale ou polygonale (par exemple carrée, rectangulaire, triangulaire, hexagonale). La deuxième dimension transversale 113, appelée également dimension mineure, qui correspond globalement à une épaisseur de la diode 11 transversalement à la première direction 112a, est préférentiellement comprise entre 5 nm et 20 µm, de préférence entre 50 nm et 5 µm. Le rapport entre la première dimension longitudinale 112, appelée également dimension majeure, et la deuxième dimension transversale 113, est supérieur à 1, de préférence supérieur ou égal à 5, et encore plus préférentiellement supérieur ou égal à 10. Dans certains modes de réalisation, la deuxième dimension transversale 113 peut être inférieure ou égale à environ 1 µm, de préférence comprise entre 100 nm et 1 µm, plus préférentiellement entre 100 nm et 800 nm. Dans certains modes de réalisation, la première dimension longitudinale 112, qui correspond globalement à la hauteur de la diode électroluminescente 11 suivant la première direction 112a, est supérieure ou égale à 50 nm, de préférence comprise entre 50 nm et 50 µm, plus préférentiellement entre 1 µm et 20 µm.

L'invention concerne notamment un dispositif optoélectronique 10 dans lequel la première dimension longitudinale 112 et la deuxième dimension transversale 113 des diodes électroluminescentes 11 sont toutes deux inférieures ou égales à 20 µm.

De façon générale, chaque diode électroluminescente 11 comprend des éléments semiconducteurs dont une première portion dopée selon un premier type de dopage pour jouer le rôle de jonction dopée P, une deuxième portion formant une partie active et une troisième portion dopée selon un deuxième type de dopage pour jouer le rôle de jonction dopée N. Les éléments semiconducteurs des diodes électroluminescentes 11 présentent une forme tridimensionnelle, ce qui inclut la forme filaire, la forme conique ou tronconique ou encore la forme pyramidale.

Dans la description et sur les figures, les modes de réalisation sont décrits pour le cas particulier non limitatif où les diodes électroluminescentes 11 tridimensionnelles ont une forme de fil cylindrique dont la section de coupe est quelconque, par exemple circulaire.

De manière générale, chaque diode électroluminescente 11 est connectée électriquement à la première électrode inférieure qui est formée dans le substrat 101.

A titre d'exemple, les diodes électroluminescentes 11 peuvent être, au moins en partie, formées à partir de matériaux semiconducteurs de groupe IV comme du silicium ou du germanium ou bien comportant majoritairement un composé III-V, par exemple des composés III-N. Des exemples du groupe III comprennent le gallium, l'indium ou l'aluminium. Des exemples de composés III-N sont GaN, AIN, InGaN ou AlInGaN. D'autres éléments du groupe V peuvent également être utilisés, par exemple, le phosphore, l'arsenic ou l'antimoine. De façon générale, les éléments dans le composé III-V peuvent être combinés avec différentes fractions molaires. Il convient de préciser que les diodes électroluminescentes 11 peuvent indifféremment être formées à partir de matériaux semiconducteurs comportant majoritairement un composé II-VI. Le dopant peut être choisi, dans le cas d'un composé III-V, parmi le groupe comprenant un dopant de type P du groupe II, par exemple du magnésium, du zinc, du cadmium ou du mercure, un dopant du type P du groupe IV par exemple du carbone, ou un dopant de type N du groupe IV, par exemple du silicium, du germanium, du sélénium, du souffre, du terbium ou de l'étain.

La portion active des diodes électroluminescentes 11 correspond à la ou les couches depuis lesquelles est émise la majorité des rayons lumineux fournis par les diodes électroluminescentes 11. Elle peut comporter des moyens de confinement des porteurs de charge électrique, tels que des puits quantiques. Elle est, par exemple, constituée d'une alternance de couches de GaN et d'InGaN. Les couches de GaN peuvent être dopées ou non. Alternativement, la portion active est constituée par une unique couche d'InGaN.

De manière générale, les diodes électroluminescentes 11 peuvent être obtenues par toute technique de l'homme du métier comme par exemple : un dépôt chimique en phase vapeur (« CVD » sigle anglais pour « Chemical Layer Déposition »), un dépôt de couche atomique (« ALD » sigle anglais pour « Atomic Layer Déposition »), ou dépôt physique en phase vapeur (« PVD » sigle anglais pour « Physical Vapor Déposition ») ou encore par épitaxie par jet moléculaire « Molecular Beam Epitaxy » selon l'expression anglaise consacrée (« MBE »), ou encore (« EPVOM »), aussi connue sous les acronymes anglophones (« MOVPE ») pour l'épitaxie en phase vapeur ou le dépôt en phase vapeur d'organométalliques dont l'acronyme anglais est « MOCVD » pour « Metal Organic Chemical Vapor Deposition ».

A titre d'exemple, chaque diode électroluminescente 11 est connectée électriquement à la seconde électrode supérieure 21 représentée sur la figure 1. La seconde électrode supérieure 21 recouvre au moins en partie la diode électroluminescente 11 de sorte que lorsqu'une tension est appliquée entre la première électrode inférieure et la seconde électrode supérieure 21, des rayons lumineux sont émis depuis la partie active de la diode électroluminescente 11. La seconde électrode supérieure 21 est préférentiellement transparente à ces rayons lumineux. Elle peut être formée par exemple d'un oxyde conducteur transparent (« TCO » pour « Transparent Conductive Oxyde » selon l'expression anglaise consacrée) comme un oxyde d'indium dopé avec de l'étain (« ITO » selon la terminaison anglaise pour « Indium Tin Oxyde ») ou un oxyde de zinc dopé par exemple avec de l'aluminium. L'homme du métier peut utiliser toute technique connue pour mettre en oeuvre cette seconde électrode supérieure 21. La seconde électrode supérieure 21 peut s'étendre au-delà des parois de la diode électroluminescente 11, notamment sensiblement parallèlement à la face support 101a. La seconde électrode supérieure 21 peut, dans un exemple particulier non limitatif, être recouverte au moins en partie par un métal pour améliorer la conductivité. L'homme du métier peut utiliser toute technique connue pour réaliser une reprise de contact sur la seconde électrode supérieure 21 depuis l'extérieur du dispositif optoélectronique 10.

Les diodes électroluminescentes 11 peuvent être également enveloppées au moins en partie par une couche de passivation 114, comme cela est illustré sur la figure 1. La couche de passivation 114 peut être réalisée en un matériau électriquement isolant au moins partiellement transparent. La couche de passivation 114 est formée par exemple en SiN ou en SiON. L'épaisseur maximale de la couche de passivation 114 est de préférence comprise entre 250 nm et 50 µm et préférentiellement avec une épaisseur d'environ 1 µm.

Sur la figure 1, la diode électroluminescente 11 est recouverte par la seconde électrode supérieure 21, elle-même recouverte par la couche de passivation 114. Dans un souci de clarté, sur les figures 2 à 15, la diode électroluminescente 11 est représentée sans les couches de passivation 114 et sans la seconde électrode supérieure 21. Cependant, la diode électroluminescente 11 utilisée dans les figures 2 à 15 peut indifféremment être remplacée par celle représentée sur la figure 1 qui est recouverte par la couche de passivation 114 et par la seconde électrode supérieure 21. De même, la partie distale 11a de la diode électroluminescente 11 peut être recouverte ou non par la seconde électrode supérieure 21 et par la couche de passivation 114. Ainsi, la deuxième dimension transversale 113 peut correspondre à la dimension transversale de la diode électroluminescente 11 moyennant la présence de la seconde électrode supérieure 21 et de la couche de passivation 114.

Comme illustré sur la figure 2, le dispositif optoélectronique 10 comprend au moins une lentille optique 14 formée au-dessus de la diode électroluminescente 11 suivant le première direction 112a. La lentille optique 14 est formée sur la partie distale 11a de la diode électroluminescente 11 en étant globalement axialement alignée avec l'axe longitudinal 11b de la diode électroluminescente 11. Par « formé au-dessus », il est entendu que la lentille optique 14 est soit en contact mécanique avec la partie distale 11a de la diode électroluminescente 11, soit située à une distance inférieure à 20 µm par rapport à la partie distale 11a de la diode électroluminescente 11 avec interposition ou non d'un matériau intermédiaire.

Par « globalement alignée » ou « globalement axialement alignée », il est entendu ici soit que l'axe optique de la lentille optique 14 est collinaire à 20 µm près avec l'axe longitudinal 11b de la diode électroluminescente 11, soit que l'axe optique de la lentille optique 14 est aligné à un angle de 10° près par rapport à l'axe longitudinal 11b de la diode électroluminescente 11.

La lentille optique 14, qui est destinée à être traversée par tout ou partie des rayons lumineux émis par la diode électroluminescente 11 afin de les transformer comme cela sera expliqué plus loin, présente une surface externe apte à être traversée par ces rayons lumineux provenant de la diode électroluminescente 11 ayant une forme convexe.

En particulier, la lentille optique 14 est conformée de sorte que la forme convexe de sa surface externe se présente sous la forme d'une surface de révolution dont l'axe de révolution est sensiblement aligné avec l'axe longitudinal 11b de la diode 11 et dont la génératrice est un arc de cercle. L'axe de révolution matérialise alors l'axe optique de la lentille optique 14. Par « sensiblement aligné », il est entendu ici soit que l'axe de révolution de la surface de révolution est collinaire à 20 µm près avec l'axe longitudinal 11b de la diode électroluminescente 11, soit que l'axe de révolution de la surface de révolution est aligné à un angle de 10° près par rapport à l'axe longitudinal 11b de la diode électroluminescente 11. Il est rappelé qu'une surface de révolution, par sa définition mathématique, correspond à la surface spatiale générée par la rotation à 360° de la génératrice susmentionnée autour de l'axe de révolution.

La surface de révolution présente une section de coupe, vue dans tout plan de coupe incluant l'axe de révolution, en forme d'arc outrepassé. Cela signifie que la génératrice est alors un arc de cercle recouvrant un secteur angulaire strictement supérieur à 180°.

La lentille optique 14 est formée avantageusement dans un matériau d'indice optique compris entre 1,4 et 2,2 et plus préférentiellement entre 1,4 et 1,6.

La lentille 14 peut être formée de borosilicate, de verre, de silice SiO₂, d'Al₂O₃, de saphir, de polymère, de polymère thermo-formable, de résine photosensible, de plastique, ou encore d'un liquide.

La lentille optique 14 présente une forme de sphère. Cette forme permet avantageusement de collecter un maximum de rayons lumineux issus de la diode électroluminescente 11 grâce à une distance focale réduite.

La lentille optique 14 et la partie distale 11a de la diode électroluminescente 11 peuvent être séparées l'une de l'autre par une distance D2, comprise entre 0 et 20 µm. La lentille optique 14 et la partie distale 11a de la diode électroluminescente 11 peuvent ainsi être en contact mécanique ponctuel tangentiel ou plan, ou être distantes l'une de l'autre par une distance non nulle inférieure à 20 µm.

La lentille optique 14 permet avantageusement de transformer optiquement les rayons lumineux qui la traversent, de sorte à globalement les focaliser ou améliorer leur directivité en les rendant les plus parallèles possibles entre eux.

Dans le reste du texte, les termes « transformer optiquement les rayons lumineux » s'entendent au sens large et comprennent notamment les actions de focaliser ou de rendre sensiblement parallèles ou d'assurer une collimation ou d'améliorer la directivité de tout ou partie des rayons lumineux émis par la diode électroluminescente 11 qui traversent la lentille optique 14.

Cela permet avantageusement d'augmenter l'efficacité lumineuse d'une diode électroluminescente 11 tridimensionnelle filaire dans un angle solide donné car, en l'absence de la lentille optique 14, une partie de la lumière émise par la diode électroluminescente 11 est perdue en raison de son émission en dehors de cet angle solide.

Plusieurs lentilles optiques 14 peuvent être agencées en série suivant l'axe longitudinal 11b, par exemple en combinant une première lentille optique sphérique et une deuxième lentille optique tronquée et superposée à la première lentille optique pour, par exemple, rendre parallèles des rayons lumineux issus de la diode électroluminescente 11 grâce à cette première lentille optique puis les focaliser à l'aide de cette deuxième lentille optique.

La surface de révolution de la lentille optique 14 peut être conformée de sorte que l'aire de la section de la surface externe en coupe perpendiculairement à son axe de révolution présente une valeur maximale au niveau d'un plan principal « P1 » sensiblement parallèle à la face support 101a où la section de coupe présente un diamètre maximal D1 supérieur ou égal à la deuxième dimension transversale 113 de la diode électroluminescente 11.

Préférentiellement, le diamètre D1 est compris entre 0,1 µm à 100 µm. Une lentille optique 14 ayant un diamètre D1 tel que décrit permet de récupérer un maximum des rayons lumineux issus d'une diode électroluminescente 11. Cela permet avantageusement d'augmenter l'efficacité lumineuse et le rendement global.

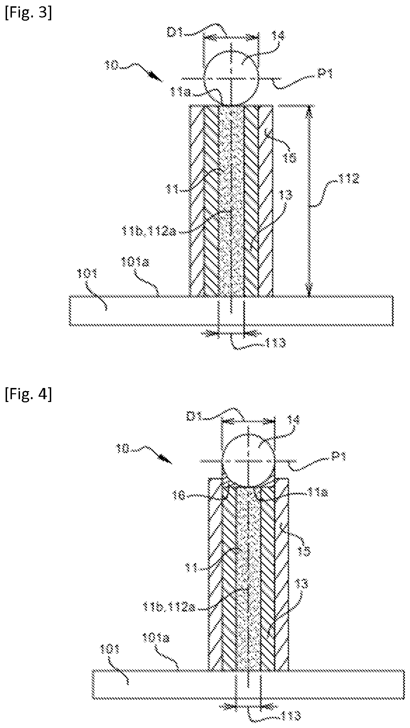

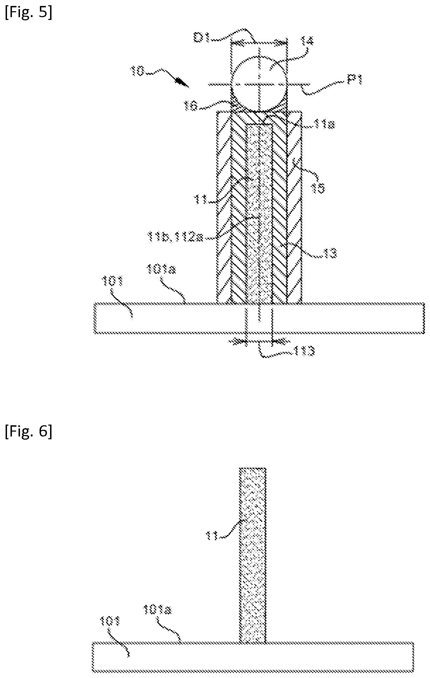

Comme illustré sur les figures 4 et 5 qui représentent un deuxième et un troisième modes de réalisation, tout ou partie de l'espace compris entre la partie de la lentille optique 14 située en regard de la partie distale 11a de la diode électroluminescente 11 et la partie distale 11a de la diode électroluminescente 11, est rempli d'un matériau optique 16 d'indice optique compris entre 1,4 et 2,2, plus préférentiellement entre 1,4 et 2, dans tous les cas inférieur ou égal à l'indice optique d'un matériau de la lentille optique 14.

Dans l'ensemble du texte, les termes « indice optique » et « indice de réfraction » sont équivalents.

Le matériau optique 16 peut par exemple être formé de SiON ou de SiN ou de borosilicate, de verre, de silice SiO₂, d'Al₂O₃, de saphir, de polymère, de polymère thermoformable, de résine photosensible ou encore de plastique. Le matériau optique 16 peut par exemple avoir une aptitude à être gravé de façon isotrope par la mise en oeuvre d'une première méthode de gravure. Cette première méthode de gravure peut, dans un exemple, être une gravure chimique humide ou en phase vapeur en utilisant par exemple de l'acide fluorhydrique HF.

Les diodes électroluminescentes 11 sont au moins partiellement entourées par une couche d'encapsulation 13. La couche d'encapsulation 13 peut comprendre une matrice d'un matériau inorganique au moins partiellement transparent dans laquelle sont éventuellement réparties des particules d'un matériau diélectrique. L'indice de réfraction du matériau diélectrique composant les particules est strictement supérieur à l'indice de réfraction du matériau composant la matrice. Selon un exemple, la couche d'encapsulation 13 comprend une matrice en silicone, typiquement en polysiloxane, et comprend, en outre, des particules d'un matériau diélectrique réparties dans la matrice. Les particules sont formées dans tout type de matériau permettant l'obtention de particules de dimensions nanométriques relativement sphériques ayant un indice de réfraction adapté. A titre d'exemple, les particules peuvent être en oxyde de titane (TiO₂), en oxyde de zirconium (ZrO₂), en sulfure de zinc (ZnS), en sulfure de plomb (PbS) ou en silicium amorphe (Si). Le diamètre moyen d'une particule correspond au diamètre de la sphère de même volume. Le diamètre moyen des particules du matériau diélectrique est de préférence compris entre 2 nm et 250 nm. La concentration en volume des particules par rapport au poids total de la couche d'encapsulation 13 est de préférence comprise entre 1 % et 50 %. Selon un autre exemple, le matériau inorganique est choisi parmi le groupe comprenant les oxydes de silicium du type SiOₓ où x est un nombre réel strictement supérieur à 0 et inférieur ou égal à 2, les oxydes de silicium du type SiO_{y}N_{z} où y est un nombre réel strictement supérieur à 0 et inférieur ou égal à 2 et z est strictement supérieur 0 et inférieur ou égal à 0,5, et l'oxyde d'aluminium (Al₂O₃). La couche d'encapsulation 13 peut être réalisée en un matériau organique au moins partiellement transparent. Selon un exemple, la couche d'encapsulation 13 est formée en polyimide. Selon un autre exemple, la couche d'encapsulation 13 est formée dans un polymère époxyde qui comprend, en outre, des particules d'un matériau diélectrique réparties dans la matrice. Les particules peuvent être en oxyde de titane (TiO₂), en oxyde de zirconium (ZrO₂), en sulfure de zinc (ZnS), en sulfure de plomb (PbS) ou en silicium amorphe (Si). Pour améliorer l'efficacité lumineuse du dispositif optoélectronique 10, un traitement de surface de texturation peut être appliqué à la couche d'encapsulation 13. Dans un autre exemple, la couche d'encapsulation 13 est une résine ou une résine photosensible. Dans un autre exemple, la couche d'encapsulation 13 contient des convertisseurs de lumière comme des plots photoluminescents ou des plots quantiques. Les plots photoluminescents sont conçus de sorte à absorber et convertir au moins une partie des rayons lumineux incidents, par exemple de couleur bleue, émanant de la diode électroluminescente 11 et émettre des rayons lumineux sortants d'une couleur différente par exemple verte ou rouge. Ces plots photoluminescents peuvent former avantageusement un filtre de longueur d'onde comme décrit dans la suite. Dans un exemple, la couche d'encapsulation 13 ne recouvre pas la partie distale 11a des diodes électroluminescentes 11 et entoure uniquement leurs faces latérales qui relient la partie proximale et la partie distale 11a. A l'inverse, il est possible que la couche d'encapsulation 13 recouvre en plus la partie distale 11a des diodes électroluminescentes 11. L'épaisseur de la couche d'encapsulation 13 prise parallèlement à la face support 101a à partir de la face latérale des diodes électroluminescentes 11 est comprise de préférence entre 500 nm et 50 µm. Dans un exemple illustré sur la figure 5, la couche d'encapsulation 13 contient des convertisseurs de couleur car elle permet que des longueurs d'onde parasites ne soient émises en dehors du dispositif optoélectronique 10.

Les parois 15 aptes à réfléchir les rayons lumineux émis par les diodes électroluminescentes 11 peuvent être, par exemple, sensiblement parallèles à l'axe longitudinal 11b des diodes électroluminescentes 11 pour avantageusement réfléchir le maximum de rayons lumineux. Les parois 15 peuvent par exemple être obtenues par gravure de la couche d'encapsulation 13 et remplissage au moins partiel par un matériau réfléchissant, comme par exemple un métal. Les parois 15 permettent, associées à la couche d'encapsulation 13, d'augmenter l'extraction lumineuse vers la lentille optique 14. Il reste possible de prévoir que les parois 15 ne soient ni planes ni verticales. Les parois 15 sont préférentiellement d'une hauteur, comptée selon l'axe longitudinal 11b à partir de la face support 101a du substrat 11, supérieure à la hauteur de la couche d'encapsulation 13 mesurée de la même manière. Ainsi, les rayons lumineux émis par la diode électroluminescente 11 peuvent être réfléchis et/ou guidés de façon maximisée vers la lentille optique 14.

Comme il l'a déjà été indiqué, l'invention concerne aussi un procédé de fabrication d'un dispositif optoélectronique 10, notamment le dispositif optoélectronique 10 tel que décrit précédemment.

De manière générale, le procédé de fabrication du dispositif optoélectronique 10 comprend les étapes suivantes :
a) formation d'un substrat 101 délimitant une face support 101a ;
b) formation d'au moins une diode électroluminescente 11 présentant une forme tridimensionnelle comprenant une hauteur suivant un axe longitudinal 11b s'étendant selon une première direction 112a orientée transversalement à la face support 101a, et présentant une première dimension longitudinale 112 comptée selon l'axe longitudinal 11b entre une partie proximale de la diode électroluminescente 11 tournée vers la face support 101a et une partie distale 11a de la diode électroluminescente 11 opposée, le long de la première direction 112a, à ladite partie proximale, et au moins une deuxième dimension transversale 113 correspondant à une dimension de ladite forme tridimensionnelle comptée perpendiculairement à l'axe longitudinal 11b.

La première dimension longitudinale 112 et la deuxième dimension transversale 113 sont chacune inférieures ou égales à sensiblement 20 µm.

Le procédé de fabrication comprend également une étape i) de formation d'au moins une lentille optique 14 au-dessus de la partie distale 11a de la diode électroluminescente 11 suivant la première direction 112a à un emplacement tel que la lentille optique 14 est globalement axialement alignée avec l'axe longitudinal 11b de la diode électroluminescente 11, la lentille optique 14 formée étant apte à transformer les rayons lumineux émis par la diode électroluminescente 11 qui traversent la lentille optique 14 et présentant une surface externe apte à être traversée par lesdits rayons lumineux ayant une forme convexe adoptant la forme d'une sphère.

Les figures 6 à 11 et 14 représentent les étapes d'un premier exemple du procédé de fabrication.

Pour former la lentille optique 14, le procédé de fabrication peut comprendre les étapes suivantes :
c) formation d'une couche d'encapsulation 13 entourant tout ou partie de la diode électroluminescente 11. La couche d'encapsulation 13 ainsi que la partie distale 11a de la diode électroluminescente 11 peuvent être également facultativement aplanies et écrêtées par une étape de polissage mécano-chimique ;
d) formation, sur la face exposée de la structure intermédiaire obtenue après l'étape de formation de couche d'encapsulation 13, d'une première couche de matériau optique 16 d'indice optique compris entre 1,4 et 2,2 et inférieur ou égal à l'indice optique de la lentille optique 14. Cette première couche de matériau optique 16 a une aptitude à être gravée de façon isotrope par la mise en oeuvre d'une première méthode de gravure comme décrit précédemment. L'épaisseur de la couche de matériau optique 16 est comprise entre 1 et 50 µm ;
e) formation, sur la surface exposée de la structure intermédiaire obtenue après l'étape de formation de la première couche de matériau optique 16, d'une couche 17 de masque dur ayant une aptitude à ne pas être gravée par la mise en oeuvre de la première méthode de gravure. Cette différence de comportement vis-à-vis de la première méthode de gravure par rapport à la couche de matériau optique 16 permet avantageusement d'obtenir une structure en surplomb. La couche 17 de masque dur a de préférence une épaisseur comprise entre 50 nm et 5 µm. La couche 17 de masque dur peut être réalisée par exemple en SiN, SiON ou en SiOCH ;
f) gravure d'une première ouverture 171, par la mise en oeuvre d'une deuxième méthode de gravure, à travers la couche 17 de masque dur obtenue à l'étape e), la première ouverture 171 ayant des dimensions et des formes sensiblement identiques à celles d'une section de coupe de la diode électroluminescente 11 suivant un plan parallèle à la face support 101a, la première ouverture 171 de la couche 17 de masque dur étant située au-dessus de la diode électroluminescente 11 dans le prolongement de l'axe longitudinal 11b. La deuxième méthode de gravure est, par exemple, de type gravure par des ions actifs « RIE » pour « reactive ion etching » selon l'expression anglaise consacrée) ou de type gravure plasma ;
g) gravure d'au moins une cavité 19, par la mise en oeuvre de la première méthode de gravure au niveau de la première ouverture 171 obtenue à l'étape f), dans tout ou partie de l'épaisseur de la première couche de matériau optique 16, la cavité 19 ainsi obtenue ayant une forme concave complémentaire de la surface convexe de la lentille optique 14 et étant adaptée à la formation ultérieure de la lentille optique 14 à l'étape i) directement dans la cavité 19 ;
h) retrait de la couche 17 de masque dur.

Cette étape h) peut être réalisée, par exemple, par polissage mécano-chimique ou à l'aide d'une chimie sélective humide.

L'étape i) décrite précédemment consiste entre autre en l'agencement de la lentille optique 14 dans la cavité 19 concave. Par « agencement », il est entendu la « formation in situ » ou bien la « formation ex situ avec placement ».

Dans un exemple, les étapes a), b) et i) sont successives avec ou sans d'autres étapes intercalaires.

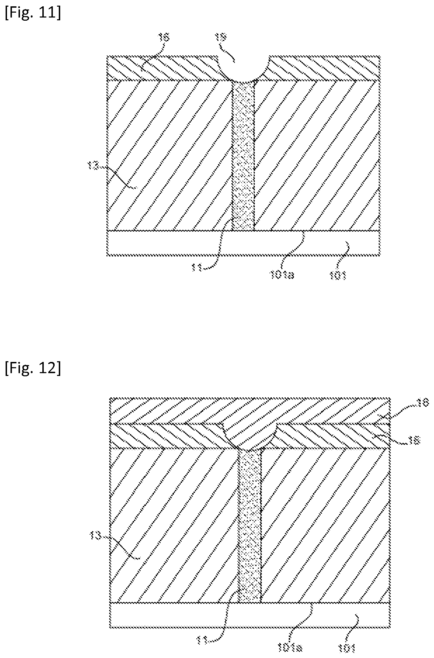

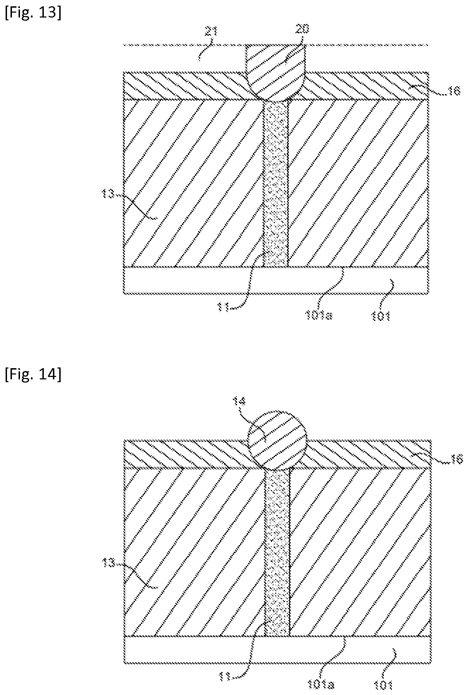

Dans un deuxième exemple illustré sur les figures 12 et 13, la lentille optique 14 est formée de façon in-situ grâce à la mise en oeuvre des trois sous-étapes successives suivantes :
- une première sous-étape i1) consistant à former une couche de polymère 18 sur la surface libre obtenue après que la couche de masque dur 17 ait été retirée, la couche de polymère 18 remplissant au moins en partie la cavité 19 concave ; pour obtenir une lentille 14 sphérique, il est préférable que la cavité 19 soit remplie par la couche de polymère 18 ;
- une deuxième sous-étape i2) consistant en la gravure d'une portion à retirer 22 de la couche de polymère 18, laissant restante au moins une portion résiduelle 20 de la couche de polymère 18 limitée à l'aplomb de la portion gravée de la première couche de matériau optique 16 ;
- une troisième sous-étape i3) consistant en un recuit de la portion résiduelle 20 de polymère où la température de recuit peut être comprise entre 100 et 300 °C ; avantageusement, le recuit permet au polymère de passer par une phase visqueuse pour obtenir avantageusement une forme sphérique par le biais des forces de tensions superficielles.

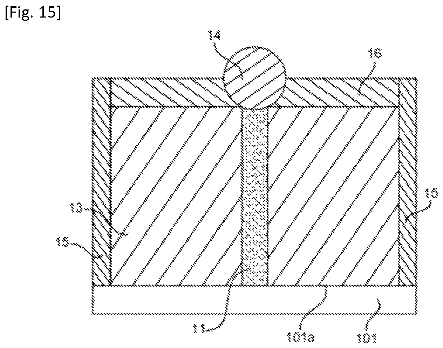

Dans un troisième exemple de procédé de fabrication illustré sur la figure 15, celui-ci comprend une étape supplémentaire j) qui consiste à former au moins une paroi 15 réfléchissante, par exemple par gravure de la couche d'encapsulation 13 et par remplissage au moins partiel avec du métal. Toute autre technique connue de l'homme du métier peut être utilisée. La paroi 15 s'étend avantageusement depuis la face support 101a du substrat 101 et sensiblement parallèlement à l'axe longitudinal 11b. Les parois 15 entourant la diode électroluminescente 11 permettent avantageusement d'augmenter l'efficacité lumineuse par réflexions simples ou multiples vers la lentille optique 14 des rayons lumineux émis par la diode électroluminescente 11. La distance entre la diode électroluminescente 11 et les parois 15 est de préférence supérieure ou égale à 500 nm.

## Revendications

1. Dispositif optoélectronique (10) comportant un substrat (101) délimitant une face support (101a) et au moins une diode électroluminescente (11) formée sur la face support (101a), ladite au moins une diode électroluminescente (11) ayant une forme tridimensionnelle comprenant une hauteur suivant un axe longitudinal (11b) s'étendant selon une première direction (112a) orientée transversalement à la face support (101a) et présentant une première dimension longitudinale (112) comptée suivant l'axe longitudinal (11b) entre une partie proximale de la diode électroluminescente (11) tournée vers la face support (101a) et une partie distale (11a) de la diode électroluminescente (11) opposée, le long de la première direction (112a), à ladite partie proximale, et au moins une deuxième dimension transversale (113) correspondant à une dimension de ladite forme tridimensionnelle comptée perpendiculairement à l'axe longitudinal (11b),
dans lequel le rapport entre la première dimension longitudinale (112) et la deuxième dimension transversale (113) est supérieur à 1,
dans lequel la première dimension longitudinale (112) et la deuxième dimension transversale (113) sont chacune inférieures ou égales à sensiblement 20 µm, le dispositif optoélectronique (10) comportant une lentille optique (14) apte à transformer les rayons lumineux émis par la diode électroluminescente (11) qui traversent ladite lentille optique (14), ladite lentille optique (14) étant formée au-dessus de la partie distale (11a) de la diode électroluminescente (11) suivant la première direction (112a) et globalement axialement alignée avec l'axe longitudinal (11b) de la diode électroluminescente (11) et présentant une surface externe apte à être traversée par au moins une partie desdits rayons lumineux à transformer, ladite surface externe ayant une forme convexe,
dans laquelle la forme convexe de la surface externe de la lentille optique (14) se présente sous la forme d'une surface de révolution dont l'axe de révolution est sensiblement aligné avec l'axe longitudinal (11b) de la diode électroluminescente (11) et dont la génératrice est un segment arqué, **caractérisé en ce que** la surface de révolution adopte la forme d'une sphère.

2. Dispositif optoélectronique (10) selon la revendication 1, dans lequel la lentille optique (14) est formée dans un matériau ayant un indice de réfraction compris entre 1,4 et 2,2.

3. Dispositif optoélectronique (10) selon l'une des revendications 1 ou 2, dans lequel la lentille optique (14) et la partie distale (11a) de la diode électroluminescente (11) sont en contact mécanique.

4. Dispositif optoélectronique (10) selon l'une des revendications 1 à 3, dans lequel au moins une partie de la lentille optique (14) et la partie distale (11a) de la diode électroluminescente (11) sont séparées l'une de l'autre avec interposition d'une distance (D2) comprise entre 5 nm et 20 µm.

5. Dispositif optoélectronique (10) selon l'une des revendications 1 à 4, dans lequel un matériau optique (16), d'indice de réfraction compris entre 1,4 et 2,2 et inférieur ou égal à un indice de réfraction de la lentille optique (14), remplit tout ou partie de l'espace compris entre la partie distale (11a) de la diode électroluminescente (11) et la partie de la lentille optique (14) tournée vers la partie distale (11a) de la diode électroluminescente (11).

6. Dispositif optoélectronique (10) selon l'une des revendications 1 à 5, dans lequel tout ou partie de la diode électroluminescente (11) est entourée par un matériau d'encapsulation (13).

7. Dispositif optoélectronique (10) selon la revendication 6, dans lequel, lorsqu'il est vu perpendiculairement à l'axe longitudinal (11b), le matériau d'encapsulation (13) est entouré par au moins une paroi (15) apte à réfléchir les rayons lumineux émis par la diode électroluminescente (11).

8. Procédé de fabrication d'un dispositif optoélectronique (10), le procédé comprenant les étapes successives suivantes :
a) formation d'un substrat (101) délimitant une face support (101a) ;
b) formation d'au moins une diode électroluminescente (11) présentant une forme tridimensionnelle comprenant une hauteur suivant un axe longitudinal (11b) s'étendant selon une première direction (112a) orientée transversalement à la face support (101a) et présentant une première dimension longitudinale (112) comptée suivant l'axe longitudinal (11b) entre une partie proximale de la diode électroluminescente (11) tournée vers la face support (101a) et une partie distale (11a) de la diode électroluminescente (11) opposée, le long de la première direction (112a), à ladite partie proximale, et au moins une deuxième dimension transversale (113) correspondant à une dimension de ladite forme tridimensionnelle comptée perpendiculairement à l'axe longitudinal (11b),
dans lequel le rapport entre la première dimension longitudinale (112) et la deuxième dimensions transversale (113) est supérieur à 1,
dans lequel la première dimension longitudinale (112) et la deuxième dimension transversale (113) sont chacune inférieures ou égales à sensiblement 20 µm ;
i) formation d'une lentille optique (14) au-dessus de la partie distale (11a) de la diode électroluminescente (11) suivant la première direction (112a) de sorte que la lentille optique (14) est globalement axialement alignée avec l'axe longitudinal (11b) de la diode électroluminescente (11), la lentille optique (14) formée étant apte à transformer les rayons lumineux émis par la diode électroluminescente (11) qui traversent la lentille optique (14) et présentant une surface externe apte à être traversée par lesdits rayons lumineux à transformer, ladite surface externe ayant une forme convexe,
dans laquelle la forme convexe de la surface externe de la lentille optique (14) se présente sous la forme d'une surface de révolution dont l'axe de révolution est sensiblement aligné avec l'axe longitudinal (11b) de la diode électroluminescente (11) et dont la génératrice est un segment arqué, **caractérisé en ce que** la surface de révolution adopte la forme d'une sphère.

9. Procédé de fabrication selon la revendication 8, comprenant les étapes suivantes, mises en oeuvre entre l'étape b) et l'étape i) :
c) formation d'un matériau d'encapsulation (13) entourant tout ou partie de la diode électroluminescente (11) ;
d) formation, sur la face exposée de la structure intermédiaire obtenue à l'étape c), d'une première couche de matériau optique (16), d'indice de réfraction compris entre 1,4 et 2,2 et inférieur ou égal à un indice de réfraction de la lentille optique (14), ladite première couche de matériau optique (16) ayant une aptitude à être gravée de façon isotrope par la mise oeuvre d'une première méthode de gravure ;
e) formation, sur la surface libre de la structure intermédiaire obtenue après l'étape d), d'une couche (17) de masque dur ayant une aptitude à ne pas être gravée lors de l'utilisation de la première méthode de gravure ;
f) gravure d'une première ouverture (171), par la mise en oeuvre d'une deuxième méthode de gravure, à travers la couche (17) de masque dur obtenue à l'étape e), la première ouverture (171) correspondant à une section de coupe de la diode électroluminescente (11) suivant un plan parallèle à la face support (101a), ladite première ouverture (171) de la couche (17) de masque dur étant située au-dessus de la diode électroluminescente (11) dans le prolongement de l'axe longitudinal (11b) ;
g) gravure d'au moins une cavité (19), par la mise en oeuvre de la première méthode de gravure au niveau de la première ouverture (171) obtenue à l'étape f), dans tout ou partie de l'épaisseur de la première couche de matériau optique (16), la cavité (19) ainsi obtenue ayant une forme concave complémentaire de la surface convexe de la lentille optique (14) et étant adaptée à la formation ultérieure de la lentille optique (14) à l'étape i) directement dans la cavité (19) ;
h) retrait de la couche (17) de masque dur.

10. Procédé de fabrication selon l'une des revendications 8 ou 9, comportant une étape j) de formation d'au moins une paroi (15) apte à réfléchir les rayonnements lumineux émis par la diode électroluminescente (11), la paroi (15) s'étendant depuis la face support (101a) sensiblement parallèlement à l'axe longitudinal (11b).

## Patentansprüche

1. Optoelektronische Vorrichtung (10), ein Substrat (101) enthaltend, das eine Trägerfläche (101a) begrenzt, und mindestens eine Leuchtdiode (11), die auf der Trägerfläche (101a) gebildet ist, wobei die mindestens eine Leuchtdiode (11) eine dreidimensionale Form hat, die eine Höhe entlang einer Längsachse (11b) umfasst, die sich in einer ersten Richtung (112a) erstreckt, die quer zur Trägerfläche (101a) orientiert ist, und eine erste Längsabmessung (112) aufweist, die entlang der Längsachse (11b) berücksichtigt wird zwischen einem proximalen Teil der zur Trägerfläche (101a) zugewandten Leuchtdiode (11) und einem distalen Teil (11a) der Leuchtdiode (11) gegenüber, entlang der ersten Richtung (112a), des proximalen Teils, und mindestens eine zweite Querabmessung (113), die einer Abmessung der dreidimensionalen Form entspricht, die senkrecht zur Längsachse (11b) berücksichtigt wird,
wobei das Verhältnis zwischen der ersten Längsabmessung (112) und der zweiten Querabmessung (113) größer als 1 ist, wobei die erste Längsabmessung (112) und die zweite Querabmessung (113) jeweils kleiner oder gleich etwa 20 µm sind, wobei die optoelektronische Vorrichtung (10) eine optische Linse (14) enthält, die geeignet ist, die von der Leuchtdiode (11) emittierten Lichtstrahlen, die die optische Linse (14) durchdringen, umzuwandeln, wobei die optische Linse (14) oberhalb des distalen Teils (11a) der Leuchtdiode (11) entlang der ersten Richtung (112a) ausgebildet ist, und insgesamt axial mit der Längsachse (11b) der Leuchtdiode (11) ausgerichtet ist, und eine äußere Oberfläche aufweist, die geeignet ist, um von mindestens einem Teil der umzuwandelnden Lichtstrahlen durchdrungen zu werden, wobei die äußere Oberfläche eine konvexe Form hat,
wobei die konvexe Form der äußeren Oberfläche der optischen Linse (14) in Form einer Rotationsfläche vorliegt, deren Rotationsachse im Wesentlichen mit der Längsachse (11b) der Leuchtdiode (11) ausgerichtet ist, und deren Generator ein gewölbtes Segment ist, **dadurch gekennzeichnet, dass** die Rotationsfläche die Form einer Kugel annimmt.

2. Optoelektronische Vorrichtung (10) nach Anspruch 1, wobei die optische Linse (14) aus einem Material gebildet ist, das einen Brechungsindex zwischen 1,4 und 2,2 hat.

3. Optoelektronische Vorrichtung (10) nach einem der Ansprüche 1 oder 2, wobei die optische Linse (14) und der distale Teil (11a) der Leuchtdiode (11) in mechanischem Kontakt stehen.

4. Optoelektronische Vorrichtung (10) nach einem der Ansprüche 1 bis 3, wobei mindestens ein Teil der optischen Linse (14) und der distale Teil (11 a) der Leuchtdiode (11) mit einem Abstand (D2) zwischen 5 nm und 20 µm voneinander getrennt sind.

5. Optoelektronische Vorrichtung (10) nach einem der Ansprüche 1 bis 4, wobei ein optisches Material (16) mit einem Brechungsindex zwischen 1,4 und 2,2 und kleiner oder gleich einem Brechungsindex der optischen Linse (14) den Raum zwischen dem distalen Teil (11a) der Leuchtdiode (11) und dem Teil der optischen Linse (14), der dem distalen Teil (11a) der Leuchtdiode (11) zugewandt ist, ganz oder teilweise ausfüllt.

6. Optoelektronische Vorrichtung (10) nach einem der Ansprüche 1 bis 5, wobei die Leuchtdiode (11) ganz oder teilweise von einem Verkapselungsmaterial (13) umgeben ist.

7. Optoelektronische Vorrichtung (10) nach Anspruch 6, wobei das Verkapselungsmaterial (13), wenn es senkrecht zur Längsachse (11b) betrachtet wird, von mindestens einer Wand (15) umgeben ist, die geeignet ist, die von der Leuchtdiode (11) emittierten Lichtstrahlen zu reflektieren.

8. Verfahren zur Herstellung einer optoelektronischen Vorrichtung (10), wobei das Verfahren folgende aufeinanderfolgende Schritte umfasst:
a) Bildung eines Substrats (101), das eine Trägerfläche (101a) begrenzt;
b) Bildung mindestens einer Leuchtdiode (11), die eine dreidimensionale Form aufweist, die eine Höhe entlang einer Längsachse (11b) umfasst, die sich in einer ersten Richtung (112a) erstreckt, die quer zur Trägerfläche (101a) orientiert ist, und eine erste Längsabmessung (112) aufweist, die entlang der Längsachse (11b) berücksichtigt wird zwischen einem proximalen Teil der zur Trägerfläche (101a) zugewandten Leuchtdiode (11) und einem distalen Teil (11a) der Leuchtdiode (11) gegenüber, entlang der ersten Richtung (112a), des proximalen Teils, und mindestens eine zweite Querabmessung (113), die einer Abmessung der dreidimensionalen Form entspricht, die senkrecht zur Längsachse (11b) berücksichtigt wird,
wobei das Verhältnis zwischen der ersten Längsabmessung (112) und der zweiten Querabmessung (113) größer als 1 ist,
wobei die erste Längsabmessung (112) und die zweite Querabmessung (113) jeweils kleiner oder gleich etwa 20 µm sind;
i) Bildung einer optischen Linse (14) oberhalb des distalen Teils (11a) der Leuchtdiode (11) entlang der ersten Richtung (112a), so dass die optische Linse (14) insgesamt axial mit der Längsachse (11b) der Leuchtdiode (11) ausgerichtet ist, wobei die gebildete optische Linse (14) geeignet ist, die von der Leuchtdiode (11) emittierten Lichtstrahlen, die die optische Linse (14) durchdringen, umzuwandeln, und eine äußere Oberfläche aufweist, die geeignet ist, von den umzuwandelnden Lichtstrahlen durchdrungen zu werden, wobei die äußere Oberfläche eine konvexe Form hat,
wobei die konvexe Form der äußeren Oberfläche der optischen Linse (14) in Form einer Rotationsfläche vorliegt, deren Rotationsachse im Wesentlichen mit der Längsachse (11b) der Leuchtdiode (11) ausgerichtet ist, und deren Generator ein gewölbtes Segment ist, **dadurch gekennzeichnet, dass** die Rotationsfläche die Form einer Kugel annimmt.

9. Herstellungsverfahren nach Anspruch 8, die folgenden Schritte umfassend, die zwischen Schritt b) und Schritt i) durchgeführt werden:
c) Bildung eines Verkapselungsmaterials (13), das die Leuchtdiode (11) ganz oder teilweise umgibt;
d) Bildung, auf der freiliegenden Fläche der in Schritt c) erhaltenen Zwischenstruktur, einer ersten Schicht aus optischem Material (16) mit einem Brechungsindex zwischen 1,4 und 2,2 und kleiner oder gleich einem Brechungsindex der optischen Linse (14), wobei die erste Schicht aus optischem Material (16) eine Fähigkeit hat, auf isotrope Weise geätzt zu werden, durch die Durchführung einer ersten Ätzmethode;
e) Bildung, auf der freien Oberfläche der Zwischenstruktur, die nach dem Schritt d) erhalten wurde, einer Hartmaskenschicht (17), die eine Fähigkeit hat, nicht geätzt zu werden, während der Verwendung der ersten Ätzmethode;
f) Ätzung einer ersten Öffnung (171), durch die Durchführung einer zweiten Ätzmethode, durch die Hartmaskenschicht (17), die in Schritt e) erhalten wurde, wobei die erste Öffnung (171) einer Schnittsektion der Leuchtdiode (11) entlang einer Ebene parallel zur Trägerfläche (101a) entspricht, wobei die erste Öffnung (171) der Hartmaskenschicht (17) oberhalb der Leuchtdiode (11) in der Verlängerung der Längsachse (11b) angeordnet ist;
g) Ätzung mindestens eines Hohlraums (19) durch die Durchführung der ersten Ätzmethode im Bereich der ersten Öffnung (171), die in Schritt f) erhalten wurde, in die gesamte oder einen Teil der Dicke der ersten Schicht aus optischem Material (16), wobei der so erhaltene Hohlraum (19) eine konkave Form hat, die zur konvexen Oberfläche der optischen Linse (14) komplementär ist, und für die anschließende Bildung der optischen Linse (14) in Schritt i) direkt in den Hohlraum (19) eingepasst ist;
h) Entfernen der Hartmaskenschicht (17).

10. Herstellungsverfahren nach einem der Ansprüche 8 oder 9, einen Schritt j) der Bildung mindestens einer Wand (15) enthaltend, die geeignet ist, die von der Leuchtdiode (11) emittierte Lichtstrahlung zu reflektieren, wobei sich die Wand (15) von der Trägerfläche (101a) im Wesentlichen parallel zur Längsachse (11b) erstreckt.

## Claims

1. Optoelectronic device (10) comprising a substrate (101) delimiting a support face (101a) and at least one light-emitting diode (11) formed on the support face (101a), said at least one light-emitting diode (11) having a three-dimensional shape comprising a height according to a longitudinal axis (11b) extending according to a first direction (112a) directed transversely to the support face (101a) and having a first longitudinal dimension (112) considered according to the longitudinal axis (11b) between a proximal portion of the light-emitting diode (11) directed towards the support face (101a) and a distal portion (11a) of the light-emitting diode (11) opposite, along the first direction (112a), to said proximal portion, and at least one second transverse dimension (113) corresponding to a dimension of said three-dimensional shape considered perpendicularly to the longitudinal axis (11b),
wherein the ratio between the first longitudinal dimension (112) and the second transverse dimension (113) is greater than 1, wherein each of the first longitudinal dimension (112) and the second transverse dimension (113) is smaller than or equal to about 20 µm, the optoelectronic device (10) including one optical lens (14) adapted to transform the light rays emitted by the light-emitting diode (11) that cross said optical lens (14), said optical lens (14) being formed above the distal portion (11a) of the light-emitting diode (11) according to the first direction (112a) in a manner generally axially aligned with the longitudinal axis (11b) of the light-emitting diode (11) and having an outer surface adapted to be crossed by at least one portion of said light rays to transform, said outer surface having a convex shape,
wherein the convex shape of the outer surface of the optical lens (14) is in the form of a surface of revolution whose axis of revolution is substantially aligned with the longitudinal axis (11b) of the light-emitting diode (11) and whose generatrix is an arcuate segment, **characterised in that** the surface of revolution features the shape of all or part of a sphere .

2. Optoelectronic device (10) according to claim 1, wherein the optical lens (14) is made of a material having an optical index comprised between 1.4 and 2.2.

3. Optoelectronic device (10) according to claims 1 or 2, wherein the optical lens (14) and the distal portion (11a) of the light-emitting diode (11) are in mechanical contact.

4. Optoelectronic device (10) according to any of claims 1 to 3, wherein at least one portion of the optical lens (14) and the distal portion (11a) of the light-emitting diode (11) are separated from one another with interposition of a distance (D2) comprised between 5 nm and 20 µm.

5. Optoelectronic device (10) according to any of claims 1 to 4, wherein an optical material (16), with an optical index comprised between 1.4 and 2.2 and lower than or equal to an optical index of the optical lens (14), fills all or part of the space comprised between the distal portion (11a) of the light-emitting diode (11) and the portion of the optical lens (14) turned towards the distal portion (11a) of the light-emitting diode (11).

6. Optoelectronic device (10) according to any of claims 1 to 5, wherein all or part of the light-emitting diode (11) is surrounded by an encapsulation material (13).

7. Optoelectronic device (10) according to claim 6, wherein, when viewed perpendicularly to the longitudinal axis (11b), the encapsulation material (13) is surrounded by at least one wall (15) adapted to reflect the light rays emitted by the light-emitting diode (11).

8. Manufacturing method for manufacturing an optoelectronic device (10), the method comprising the following successive steps:
a) formation of a substrate (101) delimiting a support face (101a);
b) formation of at least one light-emitting diode (11) having a three-dimensional shape comprising a height according to a longitudinal axis (11b) extending according to a first direction (112a) directed transversely to the support face (101a) and having a first longitudinal dimension (112) considered according to the longitudinal axis (11b) between a proximal portion of the light-emitting diode (11) directed towards the support face (101a) and a distal portion (11a) of the light-emitting diode (11) opposite, along the first direction (112a), to said proximal portion, and at least one second transverse dimension (113) corresponding to a dimension of said three-dimensional shape considered perpendicularly to the longitudinal axis (11b),
wherein the ratio between the first longitudinal dimension (112) and the second transverse dimension (113) is greater than 1,
wherein each of the first longitudinal dimension (112) and the second transverse dimension (113) is smaller than or equal to substantially 20 µm;
i) formation of at least one optical lens (14) above the distal portion (11a) of the light-emitting diode (11) according to the first direction (112a) so that the optical lens (14) is generally axially aligned with the longitudinal axis (11b) of the light-emitting diode (11), the formed optical lens (14) being adapted to transform the light rays emitted by the light-emitting diode (11) that cross the optical lens (14) and having an outer surface adapted to be crossed by said light rays to transform, said outer surface having a convex shape,
wherein the convex shape of the outer surface of the optical lens (14) is in the form of a surface of revolution whose axis of revolution is substantially aligned with the longitudinal axis (11b) of the light-emitting diode (11) and whose generatrix is an arcuate segment, **characterised in that** the surface of revolution features the shape of all or part of a sphere.

9. Manufacturing method according to claim 8, comprising the following steps, implemented between step b) and step i):
c) formation of an encapsulation material (13) surrounding all or part of the light-emitting diode (11);
d) formation, over the exposed face of the intermediate structure obtained at step c), of a first layer of an optical material (16), with an optical index comprised between 1.4 and 2.2 and lower than or equal to an optical index of the optical lens (14), said first optical material layer (16) being adapted to be etched isotropically through the implementation of a first etching method;
e) formation, over the free surface of the intermediate structure obtained after step d), of a hard mask layer (17) adapted to not be etched during the use of the first etching method;
f) etching of a first opening (171), through the implementation of a second etching method, through the hard mask layer (17) obtained at step e), the first opening (171) corresponding to a section of the light-emitting diode (11) according to a plane parallel to the support face (101a), said first opening (171) of the hard mask layer (17) being located above the light-emitting diode (11) in the continuation of the longitudinal axis (11b);
g) etching of at least one cavity (19), through the implementation of the first etching method at the level of the first opening (171) obtained at step f), across all or part of the thickness of the first optical material layer (16), the cavity (19) obtained in this manner having a concave shape complementary to the convex surface of the optical lens (14) and being suited for the subsequent formation of the optical lens (14) at step i) directly in the cavity (19);
h) removal of the hard mask layer (17).

10. Manufacturing method according to claims 8 or 9, including a step j) of forming at least one wall (15) adapted to reflect the light radiations emitted by the light-emitting diode (11), the wall (15) extending from the support face (101a) substantially parallel to the longitudinal axis (11b).
